# EUROPEAN PATENT APPLICATION

(11) **EP 4 797 455 A1**
(43) Date of publication of application: **26.08.2026**
(21) Application number: 24879645.0
(22) Date of filing: 10.10.2024
(51) Int. Cl.: H01R 4/58, H01R 4/18, H01R 12/63

(54) **LINKING MEMBER AND BASE MATERIAL PROVIDED WITH LINKING MEMBER**

(30) Priority: 18.10.2023 JP 2023179496
(71) Applicant: Tajima Industries Ltd., Kasugai-shi, Aichi 486-0901 (JP)
(72) Inventor: FUSHIMI Akihiko, Kasugai-shi, Aichi 486-0901 (JP)
(74) Representative: Nordmeyer, Philipp Werner
(86) International application number: PCT/JP2024/036292
(87) International publication number: WO 2025/084220

(57) **Abstract**

The linking member (10) electrically connects a connection object (90) and a connection point on a cloth-form base material (80). The linking member (10) comprises a braided cord (20) formed by knitting an electroconductive yarn. The braided cord (20) is configured to be connected to the connection point by being attached to the base material (80). The linking member (10) further comprises a conductive wire (30) that is a member to be connected to the connection object (90). The linking member (10) further comprises a connection part (41) that connects the braided cord (20) and the conductive wire (30).

## Description

### TECHNICAL FIELD

The present invention relates to a linking member for electrically connecting an object to be connected and a connection point on a cloth-like base material, and to a base material provided with a linking member.

### BACKGROUND ART

Patent Literature 1 discloses a connection device for connecting a fabric body and an external circuit. The connection device is configured to fix a terminal attached to a lead wire to the fabric body using a metal button and a metal fastener.

### CITATION LIST

### Patent Literature

Patent Literature 1: JP2595665U

### SUMMARY OF INVENTION

### Technical Problem

In the connection device of Patent Literature 1, rigid members such as a metal button and a metal fastener are attached to the fabric body. As a result, even when attempting to bend a connection portion between the connection device and the fabric body, interference between the members attached to the fabric body makes it difficult to bend the connection portion. In addition, the connecting device may be detached from the fabric body due to a force applied when the connecting portion is bent.

### Solution to Problem

In accordance with one aspect of the present disclosure, a linking member for electrically connecting an object to be connected and a connection point on a cloth-like base material is provided. The linking member includes a knitted cord, a conductive wire, and a connection part. The knitted cord is formed by knitting a conductive yarn and configured to be connected to the connection point by being attached to the base material. The conductive wire is a member to be connected to the object to be connected. The connection part connects the knitted cord to the conductive wire.

To solve the foregoing objectives, a base material provided with a linking member is provided in which the knitted cord is attached to the base material by being sewn thereto.

### Advantageous Effects of Invention

It is possible to provide a linking member, and a base material provided with a linking member, that facilitate bending at a portion connected to the base material.

### BRIEF DESCRIPTION OF DRAWING

[Fig. 1] Fig. 1 is a schematic diagram illustrating a linking member according to a first embodiment.
[Fig. 2] Fig. 2 is an enlarged view illustrating a structure of a knitted cord in the linking member shown in Fig. 1.
[Fig. 3] Fig. 3 is a schematic diagram illustrating the linking member of Fig. 1, a base material, and an object to be connected.
[Fig. 4] Fig. 4 is a schematic diagram illustrating an example of use of the linking member shown in Fig. 1.
[Fig. 5] Fig. 5 is a cross-sectional view illustrating a cross-sectional structure taken along line 5-5 in Fig. 4.
[Fig. 6] Fig. 6 is a schematic diagram illustrating a linking member according to a second embodiment.
[Fig. 7] Fig. 7 is a schematic diagram illustrating an example of use of the linking member shown in Fig. 6.
[Fig. 8] Fig. 8 is a schematic diagram illustrating a linking member according to a third embodiment.
[Fig. 9] Fig. 9 is a schematic diagram illustrating an example of use of the linking member shown in Fig. 8.
[Fig. 10] Fig. 10 is a schematic diagram illustrating a linking member according to a fourth embodiment.
[Fig. 11] Fig. 11 is a schematic diagram illustrating an example of use of the linking member shown in Fig. 10.
[Fig. 12] Fig. 12 is a perspective view illustrating a linking member according to a modification.
[Fig. 13] Fig. 13 is a schematic diagram illustrating a base material provided with a linking member according to a modification.

### DESCRIPTION OF EMBODIMENTS

### First Embodiment

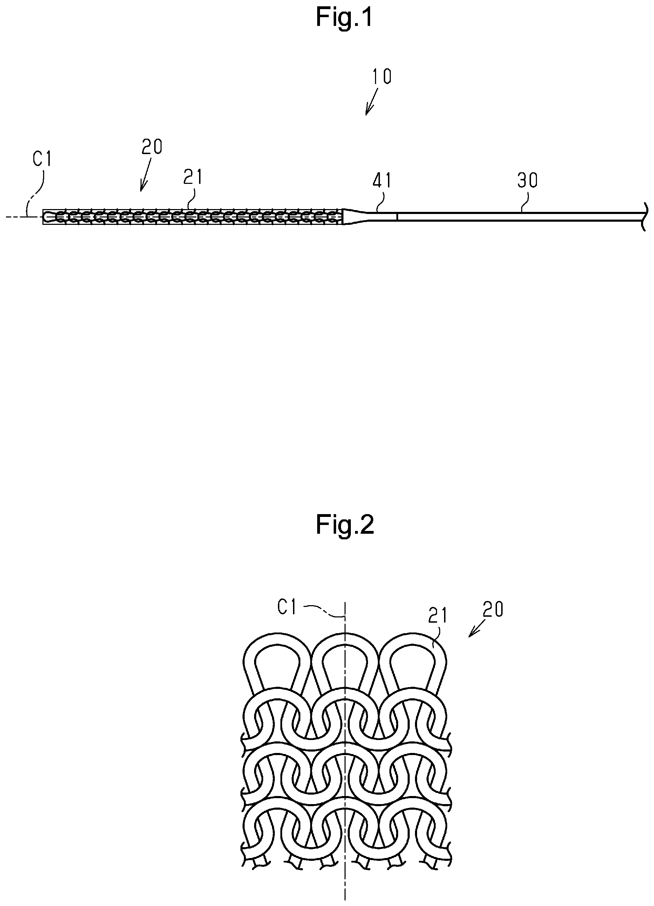

A linking member 10, which is a linking member according to a first embodiment, will be described with reference to Figs. 1 to 5.

As shown in Fig. 1, the linking member 10 includes a knitted cord 20, a conductive wire 30, and a connection part 41.

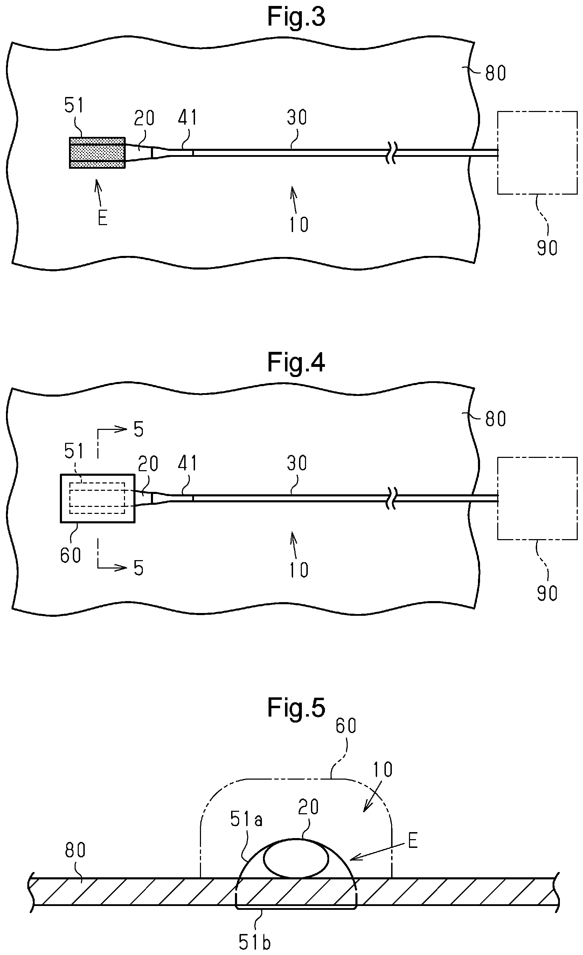

As shown in Fig. 3, the linking member 10 is capable of electrically connecting an object to be connected 90 and a connection point on a cloth-like base material 80.

Examples of the cloth-like base material 80 include a woven fabric, a knitted fabric, a nonwoven fabric, and a resin sheet. The base material 80 is preferably insulating. As another example, the base material 80 may be conductive.

Examples of the object to be connected 90 include a processing circuit such as a microcomputer and a power supply. The object to be connected 90 may be an apparatus including one or more of the processing circuit and the power supply.

### <Knitted Cord>

The knitted cord 20 is a portion to be sewn to the base material 80.

As shown in Figs. 1 and 2, the knitted cord 20 is formed by knitting a conductive yarn 21. The conductive yarn 21 may be a yarn made of a known fiber having conductivity.

The knitted cord 20 may be formed from a single yarn or from two or more yarns. When the knitted cord 20 is formed by knitting two or more yarns, not all of the yarns constituting the knitted cord 20 need to be conductive yarns. It is sufficient that at least one of the yarns constituting the knitted cord 20 be the conductive yarn 21.

The knitted cord 20 is, for example, a knitted cord made using several knitting needles. Specifically, it is a cord having a plain knit structure made using several knitting needles. The number of knitting needles is not particularly limited, but as the number of knitting needles increases, the knitted cord 20 becomes thicker. The number of knitting needles is, for example, three. Such a cord having a plain knit structure is sometimes referred to as a tubular knitted cord. Plain knitting is also referred to as jersey knitting or single jersey knitting.

As one example, the knitted cord 20 is formed by knitting the conductive yarn 21 into a tubular shape by plain knitting. It is particularly preferable that the knitted cord 20 is formed by knitting a single conductive yarn 21 into a tubular shape by plain knitting.

The term "tubular" refers to a structure having an annular peripheral wall in cross section. In the knitted cord 20, the knitted structure corresponds to the peripheral wall.

The term "annular" as used above may refer to any structure that forms a loop, which is a continuous shape with no ends. Examples of annular shapes include circular shapes, elliptical shapes, and polygons having pointed or rounded corners. The annular shape is not limited to these examples.

In Figs. 1 and 2, a central axis C1 is indicated as a line extending along the axial center of the knitted cord 20.

Fig. 2 shows a knitted structure formed by plain knitting. As shown in Fig. 2, the knitted cord 20 includes stitches arranged so as to be continuous in a transverse direction. The transverse direction corresponds to a circumferential direction of the tubular knitted cord 20, that is, a circumferential direction about the central axis C1.

In the knitted cord 20, the coarseness of the stitches is not particularly limited. For example, the knitted cord 20 may be configured such that gaps are present between the yarns. The coarseness of the stitches can be adjusted, for example, by adjusting the tension applied when pulling the finished cord during knitting. As the stitches become finer, the knitted cord 20 becomes thinner.

### <Conductive Wire>

As shown in Figs. 1 and 3, the conductive wire 30 is a portion to be connected to the object to be connected 90.

The conductive wire 30 is not particularly limited, and is, for example, a covered wire in which a conductor portion is covered by an insulating coating portion. The conductor portion may be a single wire or a stranded wire.

The manner of connecting the conductive wire 30 and the object to be connected 90 is not particularly limited. For example, the conductive wire 30 may be directly connected to the object to be connected 90. For example, a terminal may be attached to an end of the conductive wire 30 opposite to the connection part 41, and the conductive wire 30 and the object to be connected 90 may be connected via the terminal. For example, the conductive wire 30 may be connected to a wire extending from the object to be connected 90. Methods such as soldering and crimping can be employed as methods for connecting the conductive wire 30.

### <Connection Part>

As shown in Fig. 1, the connection part 41 is a portion that connects the knitted cord 20 and the conductive wire 30.

One example of the connection part 41 is a crimp fitting. Since a fitting is crimped through which an end of the knitted cord 20 and an end of the conductor portion of the conductive wire 30 are passed, the knitted cord 20 and the conductive wire 30 are crimped together.

An example of the connection part 41 as a crimp fitting will be described.

It is sufficient that the diameter of the connection part 41 be large enough for the end of the knitted cord 20 and the end of the conductor portion of the conductive wire 30 to pass therethrough.

In the linking member 10, only one of the opposite ends of the knitted cord 20 is connected to the connection part 41. In the linking member 10, the knitted cord 20 extends linearly from the connection part 41.

In the linking member 10, for example, the knitted cord 20 does not include a core material. That is, the knitted cord 20 has a hollow interior inside the peripheral wall formed by the knitted structure. In this case, the connection part 41 connects only the knitted cord 20 and the conductive wire 30. As another example, in the linking member 10, the knitted cord 20 may include a core material.

### <Connection Between Linking Member and Base Material>

As shown in Fig. 3, the knitted cord 20 of the linking member 10 is sewn to the base material 80 by a sewing thread 51. The knitted cord 20 is attached at a specified position on the base material 80, which is a connection point. The position of the connection point can be set as appropriate. The base material 80 to which the knitted cord 20 of the linking member 10 is attached corresponds to a base material provided with a linking member.

The sewing thread 51 is a conductive yarn.

For example, the knitted cord 20 can be sewn to the base material 80 by the following procedure. First, the knitted cord 20 is placed so as to overlap the base material 80. Next, the knitted cord 20 is sewn to the base material 80 using a needle threaded with the sewing thread 51. As a result, stitches connecting the knitted cord 20 and the base material 80 are formed by the sewing thread 51.

The method of sewing the knitted cord 20 to the base material 80 is not particularly limited, and may include hand sewing, machine sewing, and embroidery sewing. For example, stitches formed by the sewing thread 51 can be made so as to pass through gaps between the conductive yarns constituting the knitted cord 20.

When the knitted cord 20 is sewn to the base material 80 by the sewing thread 51, which is a conductive yarn, the stitches formed by the sewing thread 51 together with the knitted cord 20 constitute an electrical contact E. As another example, embroidery using a conductive yarn may be formed on the knitted cord 20 placed on the base material 80 so as to fix the knitted cord 20 to the base material 80.

The linking member 10 is configured to connect the knitted cord 20 to the connection point, which is a specified position on the base material 80, by sewing the knitted cord 20 to the connection point with a conductive yarn. When the knitted cord 20 of the linking member 10 is connected to the connection point, the object to be connected 90 connected to the conductive wire 30 is electrically connected to the connection point on the base material 80.

The length of the knitted cord 20 in the linking member 10 will be described.

It is sufficient that the knitted cord 20 extend from the connection part 41 so as to have a length sufficient to be sewn to the base material 80. The knitted cord 20 may have different lengths before being sewn to the base material 80 and after being sewn to the base material 80. For example, the knitted cord 20 may be cut shorter before being sewn to the base material 80. For example, the knitted cord 20 may be shortened by cutting off an excess portion after being sewn to the base material 80. For example, as the length of the knitted cord 20 sewn to the base material 80 increases, the electrical contact E is made larger.

As shown in Figs. 4 and 5, a sensor 60 may be provided on the knitted cord 20 sewn to the base material 80. The sensor 60 is, for example, a sensor made of conductive fibers.

Fig. 5 illustrates an example of an electrical contact E formed by sewing the knitted cord 20 to the base material 80 with an upper thread 51a and a lower thread 51b, which are the sewing threads 51. When a sensor 60 made of conductive fibers is connected so as to contact the knitted cord 20 and the sewing thread 51 sewn to the base material 80, that is, the electrical contact E, the sensor 60 and the object to be connected 90 are connected via the linking member 10. In this manner, when the knitted cord 20 provided at the connection point and the sensor 60 are electrically connected, the sensor 60 and the object to be connected 90 are electrically connected.

### <Operation and Advantages of the First Embodiment>

Operation and advantages of the present embodiment will now be described.

(1-1) In the linking member 10, the knitted cord 20 made of a conductive yarn is connected on the base material 80. Since the knitted cord 20 has flexibility, the connection portion between the linking member 10 and the base material 80 can be bent.

(1-2) In the present embodiment, the electrical contact E on the base material 80 is formed by the knitted cord 20 and the sewing thread 51, which is a conductive yarn, and thus flexibility is also provided in the vicinity of the electrical contact E on the base material 80. As a result, the area around the connection portion between the base material 80 and the knitted cord 20 can be bent.

(1-3) The linking member 10 can be attached to the base material 80 by a simple operation of sewing the knitted cord 20 to the base material 80. Since stitches are formed with the sewing thread 51 so as to pass through gaps between the conductive yarns constituting the knitted cord 20, the knitted cord 20 is made less likely to peel off from the base material 80.

(1-4) Since the knitted cord 20 is tubular, it can be deformed so as to be crushed by being touched from a radial direction. A linking member using, instead of the knitted cord 20, a braided cord or the like formed of a conductive yarn is taken as a comparative example. According to the linking member 10, the presence of the linking member at a touched location is less noticeable than in the comparative example, thereby reducing a sense of discomfort.

(1-5) The knitted cord 20 made of the conductive yarn 21 is sewn to the cloth-like base material 80 by the sewing thread 51, which is a conductive yarn, so that a hard feel like that of a metal fitting is less likely to be perceived when the vicinity of the electrical contact E is touched.

(1-6) Since a crimp fitting is employed as the connection part 41, which connects the knitted cord 20 to the conductive wire 30, the knitted cord 20 is connected to the conductive wire 30 with a simple structure. This suppresses an increase in the size of the connection portion between the knitted cord 20 and the conductive wire 30. Accordingly, an increase in the size of the linking member 10 is suppressed.

(1-7) Since the knitted cord 20 is formed by knitting into a tubular shape by plain knitting, the knitted cord 20 has stretchability.

(1-8) The properties of the knitted cord 20 can be changed according to the properties of the conductive yarn constituting the knitted cord 20. For example, if a conductive yarn having high stretchability is used, a knitted cord having high stretchability is obtained. That is, the stretchability of the knitted cord 20 is further improved. For example, if a conductive yarn having low stretchability is used, a knitted cord having low stretchability is obtained. For example, if a conductive yarn having a high resistance value is used, a knitted cord having a high resistance value is obtained.

(1-9) The knitted cord 20 may be formed by knitting multiple yarns. **In** this case, compared with a knitted cord formed by knitting a single conductive yarn, the knitted cord is made thicker.

(1-10) The knitted cord 20 may be formed by knitting multiple yarns. **In** this case, by using yarns having high strength as yarns to be combined with the conductive yarn, the strength of the knitted cord 20 is improved.

(1-11) The length of the knitted cord 20 made of a conductive yarn can be easily adjusted. For example, the knitted cord 20 may be knitted to a specified length, or the length may be adjusted by cutting the knitted cord 20 after knitting. Therefore, the knitted cord 20 can be adjusted to a required length for use, such as in accordance with the size of the electrical contact E to be formed on the base material 80.

(1-12) The knitted cord 20 can be manufactured without complicated processes. Consequently, the linking member 10 can also be manufactured without complicated processes.

### Second Embodiment

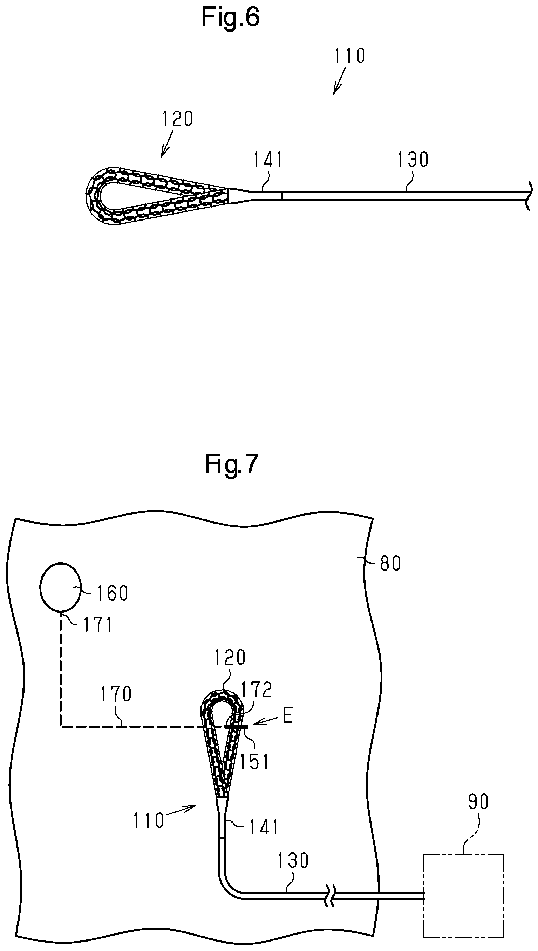

A linking member 110 according to a second embodiment will be described with reference to Figs. 6 and 7.

The linking member 110 of the second embodiment differs from the linking member 10 of the first embodiment in that the opposite ends of a knitted cord 120 are connected to a connection part 141.

As shown in Fig. 6, the connection part 141 connects the opposite ends of the knitted cord 120 and an end of a conductor portion of a conductive wire 130. Accordingly, in the linking member 110, the knitted cord 120 forms a loop.

The knitted cord 120 may have the same configuration as the knitted cord 20 of the first embodiment, except that the opposite ends of the knitted cord 120 are connected to the connection part 141 to form a loop.

The connection part 141 may have the same configuration as the connection part 41 of the first embodiment, except that it connects the opposite ends of the knitted cord 120.

The conductive wire 130 may have the same configuration as the conductive wire 30 of the first embodiment.

An example of a base material 80 to which the linking member 110 is sewn will be described with reference to Fig. 7.

Fig. 7 shows the base material 80, a sensor 160, a conductive trace 170, and the linking member 110.

The sensor 160 is formed on the base material 80, for example, by embroidery using a conductive yarn.

The conductive trace 170 is, for example, a stitch formed on the base material 80 using a conductive yarn. As long as the conductive trace 170 is constituted by a conductor, the conductive trace 170 may be constituted, for example, by attaching a fabric containing a conductive substance or the like to the base material 80.

A first end 171 of the conductive trace 170 is in contact with the sensor 160. A second end 172 of the conductive trace 170 is provided at a position separated from the sensor 160. The conductive trace 170 is formed on the base material 80 so as to connect the first end 171 to the second end 172.

As shown in Fig. 7, the knitted cord 120 of the linking member 110 is sewn to the base material 80 by a sewing thread 151 so as to be in contact with the conductive trace 170. This forms an electrical contact E that connects the knitted cord 120 to the conductive trace 170. Among portions of the base material 80 on which the conductive trace 170 is formed, a portion where the knitted cord 120 and the conductive trace 170 are in contact corresponds to a connection point on the base material 80. The sewing thread 151 may be a conductive yarn or may be a yarn having no conductivity. Preferably, the sewing thread 151 is a conductive yarn.

Fig. 7 illustrates an example in which the knitted cord 120 is sewn at a position near the second end 172 of the conductive trace 170. However, as long as the knitted cord 120 and the conductive trace 170 are in contact with each other, the position at which the knitted cord 120 is attached is not particularly limited.

### <Operation and Advantages of the Second Embodiment>

According to the second embodiment, in addition to the same operations and advantages as those of the first embodiment, the following operations and advantages are achieved.

(2-1) In the linking member 110 of the second embodiment, since the opposite ends of the knitted cord 120 are connected to the connection part 141, fraying of the knitted cord 120 is suppressed. Since fraying of the knitted cord 120 is suppressed, the knitted cord 120 becomes less likely to peel off from the base material 80.

### Third Embodiment

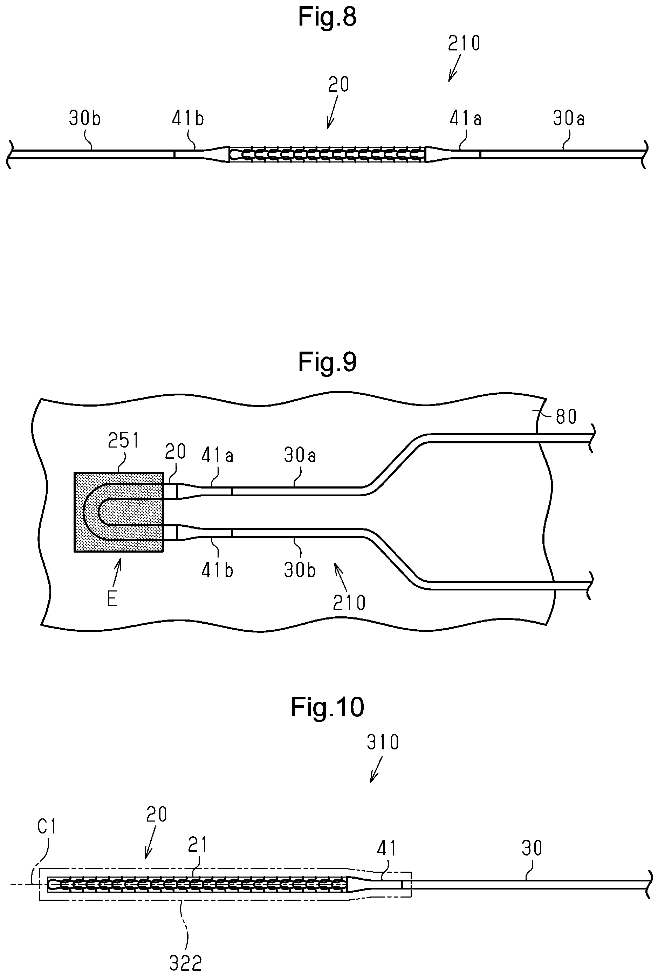

A linking member 210 according to a third embodiment will be described with reference to Figs. 8 and 9.

In the first embodiment described above, as shown in Fig. 1, the linking member 10 is illustrated in which only one end of the knitted cord 20 is connected to the conductive wire 30 via the connection part 41.

The linking member 210 of the third embodiment differs from the first embodiment in that it includes a first conductive wire 30a connected to one of the opposite ends of the knitted cord 20 and a second conductive wire 30b connected to the other end of the knitted cord 20. Components common to those of the first embodiment are denoted by the same reference numerals as in the first embodiment, and description thereof will be omitted as appropriate.

As shown in Fig. 8, the linking member 210 includes the knitted cord 20, the first conductive wire 30a, the second conductive wire 30b, a first connection part 41a, and a second connection part 41b.

The first conductive wire 30a and the second conductive wire 30b may have the same configuration as the conductive wire 30 of the first embodiment. The first conductive wire 30a and the second conductive wire 30b may be of the same type or may be a combination of different types of conductive wires. For example, the conductor portion of the first conductive wire 30a may be a single wire, and the conductor portion of the second conductive wire 30b may be a stranded wire.

As the first connection part 41a and the second connection part 41b, a configuration common to that of the connection part 41 in the first embodiment can be employed. The first connection part 41a connects one of the opposite ends of the knitted cord 20 to the first conductive wire 30a. The second connection part 41b connects the other one of the opposite ends of the knitted cord 20 to the second conductive wire 30b.

As shown in Fig. 9, the knitted cord 20 of the linking member 210 is sewn to the base material 80 by a sewing thread 251. The knitted cord 20 is sewn to a connection point on the base material 80. When the knitted cord 20 is sewn to the base material 80 using the sewing thread 251, which is a conductive yarn, the stitches formed by the sewing thread 251 and the knitted cord 20 constitute an electrical contact E on the base material 80.

In Fig. 9, as one example, an example is shown in which the knitted cord 20 is sewn to the base material 80 in a state of being curved so as to be folded back. According to such a configuration, as shown in Fig. 9, the first conductive wire 30a and the second conductive wire 30b can be arranged so as to extend in the same direction from the electrical contact E. The manner in which the knitted cord 20 is sewn is not limited to this example, and for example, the knitted cord 20 may be sewn to the base material 80 in a linear state.

### <Operation and Advantages of the Third Embodiment>

According to the third embodiment, in addition to the same operations and advantages as those of the first embodiment, the following operations and advantages are achieved.

(3-1) Since the conductive wires 30a, 30b are connected to the opposite ends of the knitted cord 20, respectively, a signal or current flowing through the linking member 210 can be divided into two.

### Fourth Embodiment

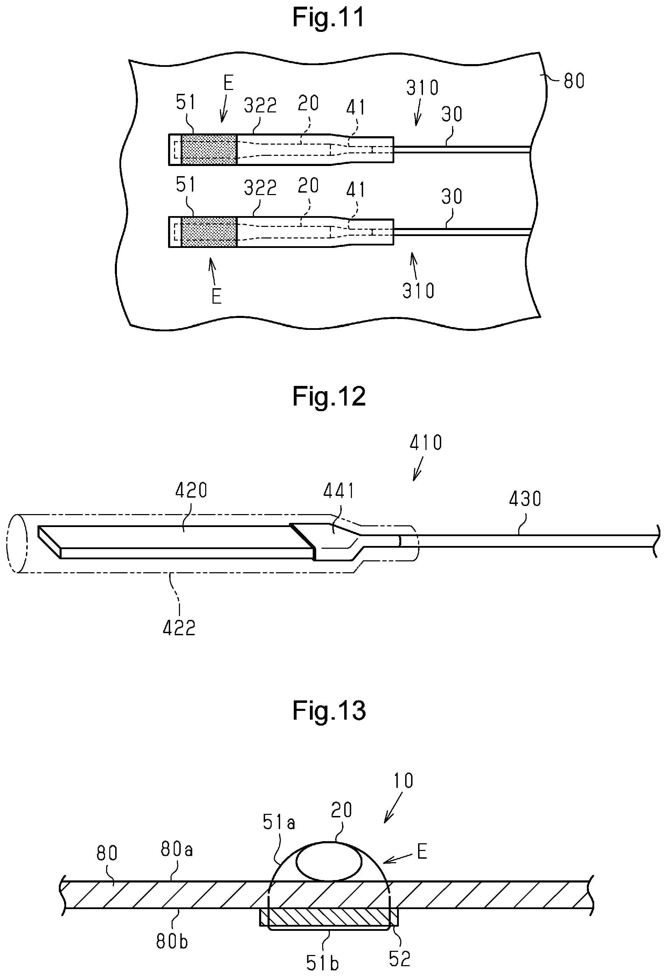

A linking member 310 according to a fourth embodiment will be described with reference to Figs. 10 and 11.

The linking member 310 of the fourth embodiment differs from the linking member 10 of the first embodiment in that it further includes an insulating covering member 322. The insulating covering member 322 is tubular.

As shown in Fig. 10, the insulating covering member 322 covers the knitted cord 20. Specifically, the knitted cord 20 is accommodated inside the tubular insulating covering member 322. Fig. 10 illustrates an example in which the insulating covering member 322 covers the entire knitted cord 20 in a direction along the axial center thereof; however, a portion of the knitted cord 20 may be left uncovered.

The end of the insulating covering member 322 that is close to the end of the knitted cord 20 on the side opposite to the connection part 41 may be open or closed.

The inner diameter of the insulating covering member 322 is not particularly limited as long as it is large enough to cover the knitted cord 20.

The length of the insulating covering member 322 is not particularly limited. For example, the insulating covering member 322 may have a length capable of covering the connection part 41 in addition to the knitted cord 20. The insulating covering member 322 does not necessarily need to cover the connection part 41. When the connection part 41 is a crimp fitting, it is preferable that the connection part 41 be covered. For example, the insulating covering member 322 may have a length capable of covering the conductive wire 30 in addition to the knitted cord 20 and the connection part 41. The insulating covering member 322 does not necessarily need to cover the conductive wire 30.

It is sufficient that the insulating covering member 322 be formed of an insulating material. The material of the insulating covering member 322 is preferably a material through which a sewing needle can pass. Specific examples of the insulating covering member 322 include an insulating tube formed of a soft insulating resin, and a heat-shrinkable tube is particularly preferable. When a heat-shrinkable tube is used as the insulating covering member 322, the shrunk heat-shrinkable tube is preferably in close contact with the knitted cord 20.

An example of attaching the linking member 310 to the base material 80 will be described with reference to Fig. 11.

For example, the knitted cord 20 covered with the insulating covering member 322 may be sewn to the base material 80 together with the insulating covering member 322 using the sewing thread 51, which is a conductive yarn. In other words, the knitted cord 20 may be sewn to the base material 80 by passing a sewing needle threaded with the sewing thread 51 through the insulating covering member 322, the knitted cord 20, the insulating covering member 322, and the base material 80. When the knitted cord 20 is sewn to the base material 80 in this manner, the knitted cord 20 can be attached to the base material 80 and the sewing thread 51 can be brought into contact with the conductive yarn 21 forming the knitted cord 20.

In the example shown in Fig. 11, electrical contacts E are formed by stitches of sewing threads 51. A base material 80 and knitted cords 20 are fixed to each other at the electrical contacts E, which are stitches formed by the sewing threads 51. The electrical contacts E are exposed on the surface of the insulating covering member 322.

In the example shown in Fig. 11, an end of the knitted cord 20 opposite to the connection part 41 is sewn to the base material 80; however, the position at which the knitted cord 20 is sewn to the base material 80 may be changed. For example, an end of the knitted cord 20 near the connection part 41 may be sewn to the base material 80.

### <Operation and Advantages of the Fourth Embodiment>

According to the fourth embodiment, in addition to the same operations and advantages as those of the first embodiment, the following operations and advantages are achieved.

(4-1) Since the knitted cord 20 can be freely deformed by bending, flexing, stretching, and the like, when the knitted cord 20 is attached to the base material 80, a portion of the knitted cord 20 that is not attached to the base material 80 may move on the base material 80 while undergoing deformation. If such a moving knitted cord 20 comes into contact with a conductor nearby, there is a risk of short-circuiting.

In this regard, in the linking member 310 of the present embodiment, the insulating covering member 322 covers the knitted cord 20. Therefore, when the linking member 310 is attached to the base material 80 as shown in Fig. 11, portions of the knitted cord 20 that are not attached to the base material 80 are insulated. This reduces the risk of short-circuiting even if the knitted cord 20 moves.

For example, when multiple linking members 310 are attached to a single base material 80 as shown in Fig. 11, even if the linking members 310 are arranged adjacent to each other, the knitted cords 20 do not come into contact with each other because the insulating covering members 322 cover the knitted cords 20. In this manner, even when multiple linking members 310 are arranged adjacent to each other, short-circuiting does not occur. Therefore, the adjacent linking members 310 can be arranged close to each other.

(4-2) Even when the entire knitted cord 20 is covered by the insulating covering member 322, an electrical contact E can be formed on a surface of the insulating covering member 322 by sewing the knitted cord 20 to the base material 80 together with the insulating covering member 322 using the sewing thread 51. The electrical contact E thus formed can be used to electrically connect a sensor or the like.

(4-3) Since the knitted cord 20 is covered by the insulating covering member 322, fraying of the knitted cord 20 is suppressed.

(4-4) In portions where the knitted cord 20 is covered by the insulating covering member 322, stitches of the knitted cord 20 are not exposed. If the stitches are exposed, there is a risk that protrusions or the like may catch on the stitches during storage, transportation, installation, or use of the linking member. In order to prevent such protrusions from catching on the stitches, care may be required in handling the linking member. In this regard, according to the linking member 310 of the present embodiment, the insulating covering member 322 covering the knitted cord 20 can suppress projections or the like from becoming caught in the stitches. Furthermore, since catching of protrusions or the like on the stitches is suppressed, handling is improved.

(4-5) Insulation treatment may be performed when attaching wiring members or the like, or after attachment. With the linking member 310 of the present embodiment, such insulation treatment can be omitted because the knitted cord 20 is covered by the insulating covering member 322.

### Modifications

The above-described embodiments may be modified as described below. Each of the above embodiments and the following modifications can be combined as long as the combined modifications remain technically consistent with each other.

In the first embodiment, an example is described in which one end of the knitted cord 20 is connected to the connection part 41. The end of the knitted cord 20 does not necessarily have to be connected to the connection part 41. For example, a portion of the knitted cord 20 located between the opposite ends thereof may be connected to the connection part 41. In this case, two linear portions of the knitted cord 20 extend from the connection part 41.

In the first embodiment, a configuration is illustrated in which the knitted cord 20 and one conductive wire 30 are connected at the connection part 41. The number of conductive wires connected to the knitted cord at the connection part is not limited to one. For example, a knitted cord and two conductive wires may be connected at a connection part. In this case, two paths branched from the connection part are formed by connecting the two conductive wires. Three or more conductive wires may be connected to a knitted cord at a connection part. According to such a configuration, signals or currents can be branched into multiple paths, as in the third embodiment.

In the first embodiment, a crimp fitting is illustrated as the connection part 41. It is sufficient that the connection part 41 be capable of connecting the knitted cord 20 and the conductive wire 30 while electrically connecting the conductive yarn 21 constituting the knitted cord 20 and the conductor portion of the conductive wire 30. For example, the connection part 41 may be a resin molded product that connects the knitted cord 20 and the conductive wire 30 in a state in which the conductive yarn 21 constituting the knitted cord 20 and the conductor portion of the conductive wire 30 are in contact with each other.

In the first embodiment, an example is described in which the sewing thread 51, for sewing the knitted cord 20 to the base material 80, is a conductive yarn. The sewing thread for sewing the knitted cord 20 to the base material 80 may be a yarn that does not have conductivity (hereinafter also referred to as a non-conductive yarn).

For example, when using a base material in which an electrical contact is formed in advance on the base material by sewing a conductive yarn thereto, the knitted cord 20 may be sewn to the base material using a non-conductive yarn such that the knitted cord 20 contacts the electrical contact. In this case, the electrical contact E for connecting a sensor 60 or the like is constituted by the electrical contact formed in advance and the knitted cord 20.

Alternatively, for a base material to which the knitted cord 20 is sewn using a non-conductive yarn, a conductive trace may be sewn using a conductive yarn so as to be in contact with the knitted cord 20.
In the second embodiment, an example is described in which the knitted cord 120 is sewn so as to contact the conductive trace 170 formed on the base material 80. Instead of this, after the knitted cord 120 is sewn at a position separated from the conductive trace 170, a stitch of a conductive yarn may be sewn so as to connect the conductive trace 170 to the knitted cord 120.

In the first embodiment, as illustrated in Figs. 4 and 5, the knitted cord 20 is sewn in an overlapping state on the same surface of the base material 80 on which the sensor 60 is attached. Instead of this, the knitted cord 20 may be sewn in an overlapping state on a surface of the base material 80 opposite to the surface on which the sensor 60 is attached. If stitches formed on the base material 80 using a conductive yarn are exposed on both a front surface and a back surface of the base material 80, the surface on which the sensor 60 is attached and the surface on which the knitted cord 20 is attached may be different as described above. In this case, conductive yarns are used as both an upper thread and a lower thread of the sewing threads for sewing the knitted cord 20.

In the fourth embodiment, the linking member 310, in which the knitted cord 20 is covered by the insulating covering member 322, is illustrated. The object to be covered by the insulating covering member is not limited to a knitted cord, and may be, for example, a strip-shaped member having conductivity. An example will be described with reference to Fig. 12.

Fig. 12 illustrates a linking member 410 including a strip-shaped member 420. The linking member 410 includes a conductive wire 430. The linking member 410 includes a connection part 441 that connects the strip-shaped member 420 to the conductive wire 430.

One example of the strip-shaped member 420 is a woven fabric woven using conductive yarns. All of the yarns constituting the strip-shaped member 420 may be conductive yarns, or, for example, warp yarns may be conductive yarns and weft yarns may be non-conductive yarns.

The strip-shaped member 420 may be an insulating sheet on which a conductive trace is formed. Examples of the conductive trace include stitches formed by a conductive yarn and application of a conductive paint. Examples of the insulating sheet include woven fabric, knitted fabric, nonwoven fabric, and resin sheets.

The linking member 410 including the strip-shaped member 420 illustrated in Fig. 12 further includes an insulating covering member 422. The insulating covering member 422 in this modification covers the strip-shaped member 420 in the same manner as the insulating covering member 322 in the fourth embodiment. The insulating covering member 422 may have the same configuration as the insulating covering member 322.

A base material provided with a linking member may be configured as illustrated in Fig. 13.

Fig. 13 shows a base material 80 and a linking member 10. An electrical contact is formed in advance on the base material 80 by a contact-forming yarn 52. The contact-forming yarn 52 is a conductive yarn. The knitted cord 20 included in the linking member 10 is sewn to the base material 80 by a sewing thread, which is a conductive yarn, so as to be electrically connected to the contact-forming yarn 52. In Fig. 13, an upper thread 51a and a lower thread 51b are illustrated as the sewing thread, and both the upper thread 51a and the lower thread 51b are conductive yarns. The knitted cord 20 is fixed to a front surface 80a, which is one surface of the base material 80. The electrical contact formed by the contact-forming yarn 52 is disposed on a back surface 80b, which is a surface opposite to the front surface 80a of the base material 80. The knitted cord 20 is sewn to the base material 80 by the upper thread 51a and the lower thread 51b, which are conductive yarns, with the sewing thread sewn over the contact-forming yarn 52. That is, a portion of the lower thread 51b exposed on the back surface 80b is located at a position farther from the base material 80 than the contact-forming yarn 52 is. Since the knitted cord 20 is sewn to the base material 80 using the upper thread 51a and the lower thread 51b, the knitted cord 20 is connected to the electrical contact formed by the contact-forming yarn 52. As a result, an electrical contact E constituted by the knitted cord 20, the contact-forming yarn 52, the upper thread 51a, and the lower thread 51b is formed. With such a base material provided with a linking member, by using the upper thread 51a and the lower thread 51b, which are conductive yarns, it is possible to electrically connect an object to be connected to a connection point on a cloth-like base material even when an electrical contact is not exposed on the surface of the base material 80 on which the knitted cord 20 is fixed.

Even when an electrical contact formed by the contact-forming yarn 52 is disposed on the surface of the base material 80 opposite to the surface on which the knitted cord 20 is fixed, the sewing thread need not be a conductive yarn, provided that a part of the contact-forming yarn 52 is exposed on the surface of the base material 80 on which the knitted cord 20 is fixed. That is, by attaching the knitted cord 20 so as to be in contact with a portion of the contact-forming yarn 52 exposed on the surface of the base material 80 on which the knitted cord 20 is fixed, the knitted cord 20 is electrically connected to the contact-forming yarn 52.

In each of the embodiments described above, a configuration in which the knitted cord is sewn to the base material is illustrated as a means for attaching the knitted cord to the base material. Alternatively, the knitted cord may be attached by adhering the knitted cord to the base material. For example, the knitted cord can be adhered to the base material using an adhesive, an adhesive tape, or the like. Alternatively, for example, a hook, clip, or other engaging member may be attached to the base material, and the knitted cord may be attached by hooking the knitted cord onto the engaging member.

A knitted cord made of a conductive yarn may be connected to each of the opposite ends of a conductive wire. A first knitted cord connected to one end of the conductive wire can be connected to a connection point on the base material. A second knitted cord connected to the other end of the conductive wire corresponds to the object to be connected.

### REFERENCE SIGNS LIST

10) Linking Member
20) Knitted Cord
21) Conductive Yarn
30) Conductive Wire
41) Connection Part
51) Sewing Thread
51a) Upper Thread
51b) Lower Thread
60) Sensor
80) Base Material
90) Object to be Connected
E) Electrical Contact

## Claims

1. A linking member for electrically connecting an object to be connected and a connection point on a cloth-like base material, the linking member comprising:
a knitted cord formed by knitting a conductive yarn and configured to be connected to the connection point by being attached to the base material;
a conductive wire that is a member to be connected to the object to be connected; and
a connection part that connects the knitted cord to the conductive wire.

2. The linking member according to claim 1, wherein the knitted cord is formed by knitting the conductive yarn into a tubular shape by plain knitting.

3. The linking member according to claim 1, wherein, at the connection part, the knitted cord and the conductive wire are crimped together.

4. The linking member according to claim 1, wherein one of opposite ends of the knitted cord is connected to the connection part such that the knitted cord extends linearly from the connection part.

5. The linking member according to claim 1, wherein opposite ends of the knitted cord are connected to the connection part such that the knitted cord forms a loop.

6. The linking member according to claim 1, further comprising an insulating covering member that covers the knitted cord.

7. A base material provided with a linking member, the base material comprising the linking member according to any one of claims 1 to 6,
wherein the knitted cord is attached to the base material by being sewn thereto.
